# EUROPEAN PATENT APPLICATION

(11) **EP 2 665 093 A1**
(43) Date of publication of application: **20.11.2013**
(21) Application number: 11855311.4
(22) Date of filing: 12.01.2011
(51) Int. Cl.: H01L 23/473, H01L 25/07, H01L 25/18, H02M 7/48, H05K 7/20

(54) **COOLER**

(71) Applicant: Toyota Jidosha Kabushiki Kaisha, Toyota-shi, Aichi 471-8571 (JP)
(72) Inventor: ISHIKAWA Keitaro, Toyota-shi Aichi 471-8571 (JP)
(74) Representative: Intès, Didier Gérard André
(86) International application number: PCT/JP2011/050305
(87) International publication number: WO 2012/095950

(57) **Abstract**

A cooler comprising a coolant space (R) which is in contact with a heat dissipator; an inflow-side coolant reservoir (Ri) which is in communication with one end of the coolant space (R) via an inflow-side narrowed portion (Rsi); and an outflow-side coolant reservoir (Ro) which is in communication with another end of the coolant space (R) via an outflow-side narrowed portion (Rso). By forming fins (22, 23) or a guide (24, 25) to stand upright in an area located near a downstream side end portion of the inflow-side coolant reservoir (Ri), the flow channel cross-sectional area is reduced and regulated, and the flow velocity of a coolant in this area is increased.

## Description

### TECHNICAL FIELD

The present invention relates to a cooler, and in particular, to an improvement in coolant flow rate.

### BACKGROUND ART

In the field of drive units including an electric motor, a drive unit case for housing the electric motor therein, and an inverter for controlling the electric motor, a drive unit having a cooling structure for cooling the inverter and the electric motor has heretofore been proposed.

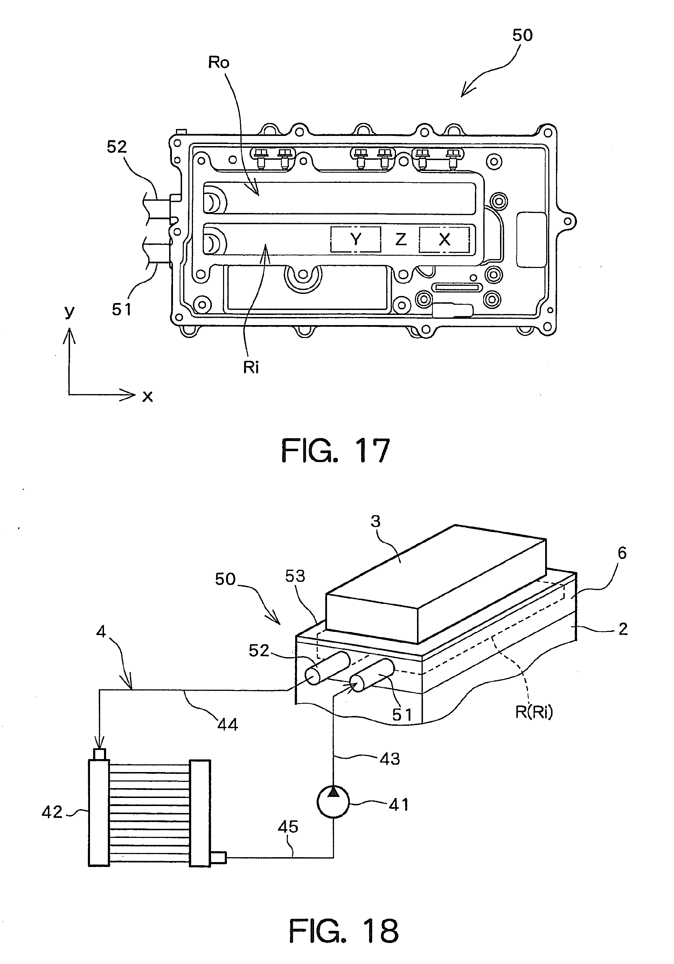

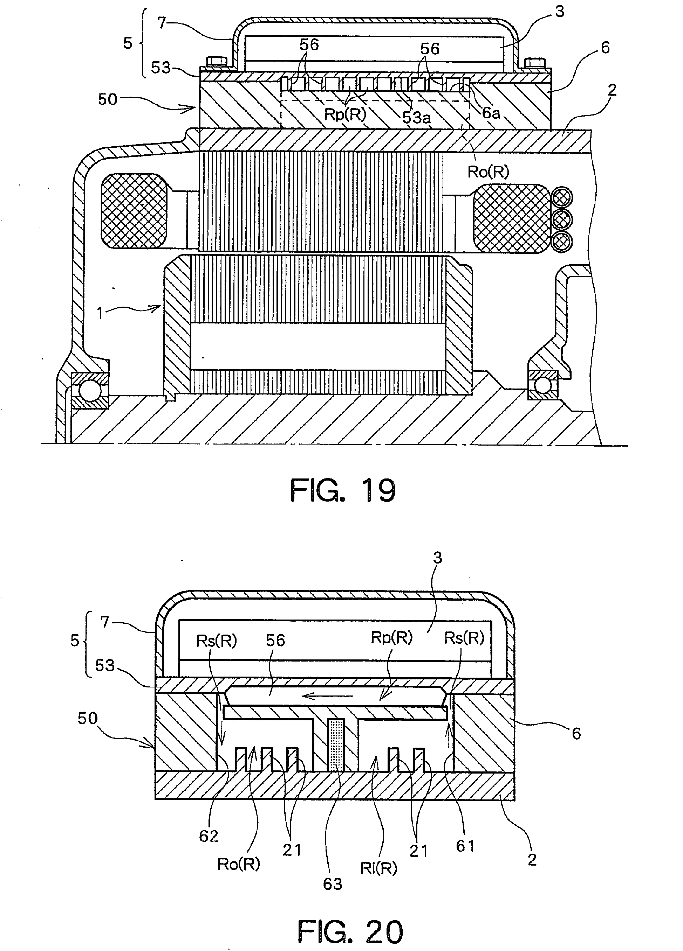

FIGs. 18, 19, and 20 illustrate a conventional cooler structure disclosed in the below-identified Patent Document 1. FIG. 18 is an overall perspective view of the cooling structure, FIG. 19 is a longitudinal cross-sectional view of the cooling structure, and FIG. 20 is a longitudinal cross-sectional view illustrating main components of the cooling structure. Heat dissipated by a heat dissipator such as an inverter 3 or an electric motor 1 is dissipated to a coolant that circulates in a coolant circulation path 4 to and from a radiator 42, so that the heat dissipator is thermally protected.

The inverter 3 includes a switching transistor that converts a direct current from a battery power source into an alternating current, associated circuit elements, and a circuit substrate on which the switching transistor and the associated circuit elements are provided. The inverter 3 is disposed on the upper face side of a heat sink 53 that is integrally provided with the substrate by being attached to the substrate itself or via another member attached to the substrate. The heat sink 53 is fixed to the bottom portion of an inverter case 7 that houses the inverter 3 therein. The lower face of the heat sink 53 is formed as a heat dissipation surface 53a that is thermally connected to the inverter 3. The inverter case 7 is formed to cover the inverter 3 housed therein to protect the inverter 3 from rainwater or dust.

The electric motor 1 is housed in a drive unit case 2. A spacer 6 is provided on the upper face of the drive unit case 2. The spacer 6 has, on the upper face thereof, an opposing surface 6a that is positioned opposite the heat dissipation surface 53a and is also thermally connected to the electric motor 1. A rectangular recessed portion is formed on the upper face of the spacer 6, so that a coolant space R is formed between the spacer 6 and the lower face of the heat sink 53, or, in other words, the heat dissipation surface 53a in a state in which the heat sink 53 is mounted on the spacer 6. The bottom face of the recessed portion forms the opposing surface 6a. A recessed portion 61 and a recessed portion 62 are formed parallel with each other on the lower face of the spacer 6. In cooperation with the upper face of the drive unit case 2, the recessed portion 61 forms an inflow-side coolant channel Ri, and the recessed portion 62 forms an outflow-side coolant channel Ro.

In the cooling structure, the coolant space R is formed between the heat dissipation surface 53a of the heat sink 53 and the opposing surface 6a of the spacer 6, and a plurality of heat dissipation fins 56 are provided within the coolant space R such that they are arranged parallel with each other and stand upright from the heat dissipation surface 53a toward the opposing surface 6a, and an inter-fin passage Rp through which the coolant flows is formed between every two of the plurality of heat dissipation fins 56 that are positioned adjacent to each other. To provide a sufficient area for heat exchange, the heat dissipation fins 56 are projected to extend from the heat dissipation surface 53a on the heat sink 53 side toward the opposing surface 6a of the spacer 6 within the coolant space R, and traverse the coolant space R in the thickness direction thereof.

The heat dissipation fins 56 are formed by cutting and raising the lower face of the heat sink 53, and the heat dissipation surface 53a is positioned close to the inverter 3 side. In forming the fins 56 to stand upright, the length of the edge portions of the heat dissipation fins 56 is configured to be shorter than the length of the base end portion at the portions in which the fins 56 are formed to stand upright from the surface from which the cutting and raising are performed, and the end faces of the inter-fin passages Rp are inclined with respect to the direction in which the heat dissipation fins 56 stand upright.

An inflow-side coolant reservoir Ri is formed by the recessed portion 61 of the spacer 6 and the upper face of the drive unit case 2 to extend in the direction in which the inter-fin passages Rp are arranged parallel with each other, and an outflow-side coolant reservoir Ro is formed by the recessed portion 62 of the spacer 6 and the upper face of the drive unit case 2 to extend in the direction in which the inter-fin passages Rp are arranged parallel with each other. The inflow-side coolant reservoir Ri and the ends of the inter-fin passages Rp on one side are joined together to communicate therebetween by a narrowed portion Rs that extends throughout the area in which the inter-fin passages Rp are arranged parallel with each other. The outflow-side coolant reservoir Ro and the ends of the inter-fin passages Rp on the other side are joined together to communicate therebetween by a narrowed portion Rs that extends throughout the area in which the inter-fin passages Rp are arranged parallel with each other. Fins 21 are provided to stand upright toward the inflow-side coolant reservoir Ri and the outflow-side coolant reservoir Ro at positions of the drive unit case 2 that are opposite the recessed portions 61 and 62, so that the area for heat transfer is increased.

A side end portion on one side of the spacer 6 has an inflow-side port 51 and an outflow-side port 52 connected thereto in parallel with each other. The inflow-side port 51 allows the coolant to flow into the inflow-side coolant reservoir Ri, and the outflow-side port 52 allows the coolant to flow out of the outflow-side coolant reservoir Ro. The coolant supplied to the inflow-side coolant reservoir Ri by means of a coolant pump 41 provided on the coolant circulation path is allowed to flow through the plurality of inter-fin passages Rp arranged parallel with each other via the narrowed portion Rs, so that the inverter 3 is cooled through the medium of the heat dissipation surface 53a. After cooling the inverter 3, the coolant is caused to flow out to the outflow-side coolant reservoir Ro via the narrowed portion Rs.

### PRIOR ART DOCUMENTS

### PATENT DOCUMENTS

Patent Document 1: JP 2008-172024 A

### SUMMARY OF THE INVENTION

### PROBLEMS TO BE SOLVED BY THE INVENTION

However, because the coolant supplied to the inflow-side coolant reservoir Ri selectively flows through the inter-fin passages Rp via a portion of the narrowed portion Rs which is located on the upstream side of the coolant stream, the flow rate of the coolant flowing through the inter-fin passages via a portion of the narrowed portion Rs which is located on the downstream side of the coolant stream is relatively low, and air dwells in a downstream side end portion of the inflow-side coolant reservoir. As a result, a problem may arise in that the cooling performance is degraded.

An object of the present invention is to provide a cooler having an inflow-side coolant reservoir and an outflow-side coolant reservoir which are in communication with coolant passages for a heat dissipation surface, or, in other words, a coolant space, via a narrowed portion, wherein the cooling performance on the downstream side of the inflow-side coolant reservoir is improved.

### MEANS FOR SOLVING THE PROBLEMS

According to one aspect of the present invention, there is provided a cooler comprising a coolant space through which a coolant flows; an inflow-side coolant reservoir which is in communication with one end side of the coolant space via an inflow-side narrowed portion; and an outflow-side coolant reservoir which is in communication with another end side of the coolant space via an outflow-side narrowed portion, wherein the inflow-side coolant reservoir and the inflow-side narrowed portion are formed to extend in a first direction, a coolant supplied to the inflow-side coolant reservoir flows along the first direction, flows through the coolant space via the inflow-side narrowed portion, and flows out to the outflow-side coolant reservoir via the outflow-side narrowed portion, and a regulator is formed in an area located near a downstream side end portion of the inflow-side coolant reservoir, the regulator reducing and regulating a flow channel cross-sectional area to increase a flow velocity of the coolant in this area.

According to one embodiment of the present invention, the regulator comprises fins. The fins may be pin fins.

According to another embodiment of the present invention, the pin fins are formed to be unevenly distributed toward the side with which the inflow-side narrowed portion is in communication.

Further, according to still another embodiment of the present invention, the pin fins are formed to have relatively large fin diameters on the side with which the inflow-side narrowed portion is in communication.

Further, according to still another embodiment of the present invention, the pin fins are formed at a relatively high density on the side with which the inflow-side narrowed portion is in communication.

Further, according to still another embodiment of the present invention, the regulator is a guide formed along the first direction.

Further, according to still another embodiment of the present invention, the guide is composed of a first portion formed along the first direction and a second portion extending in a direction approximately perpendicular to the first direction and restricting a downstream flow of the coolant.

Further, according to still another embodiment of the present invention, the cooler further comprises a second regulator formed further upstream of the area located near the downstream side end portion, the second regulator reducing and regulating the flow channel cross-sectional area of the inflow-side coolant reservoir.

Further, according to still another embodiment of the present invention, the second regulator comprises fins formed along the first direction.

Further, according to still another embodiment of the present invention, the cooler further comprises a third regulator formed between the regulator and the second regulator, the third regulator reducing and regulating the flow channel cross-sectional area of the inflow-side coolant reservoir.

Further, according to still another embodiment of the present invention, the third regulator is a projection formed in the inflow-side coolant reservoir.

### ADVANTAGES OF THE INVENTION

By employing the present invention, the amount of air dwelling in a downstream side end portion of the inflow-side coolant reservoir is reduced, and the cooling performance can be improved.

### BRIEF DESCRIPTION OF THE DRAWINGS

[FIG. 1]

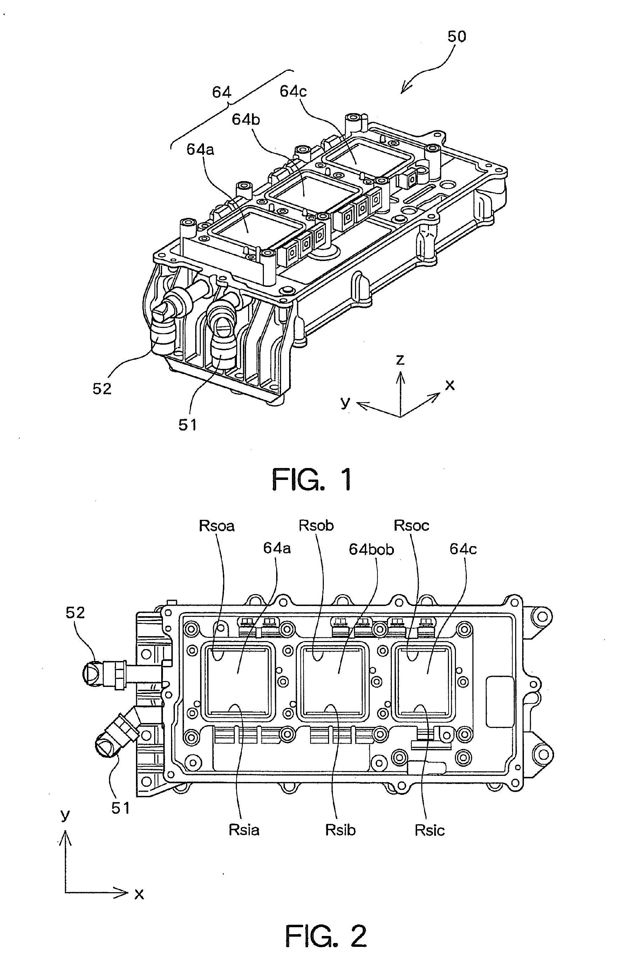

   FIG. 1 is an external perspective view illustrating a basic structure according to an embodiment.
[FIG. 2]
   FIG. 2 is a plan view illustrating the basic structure according to the embodiment.
[FIG. 3]

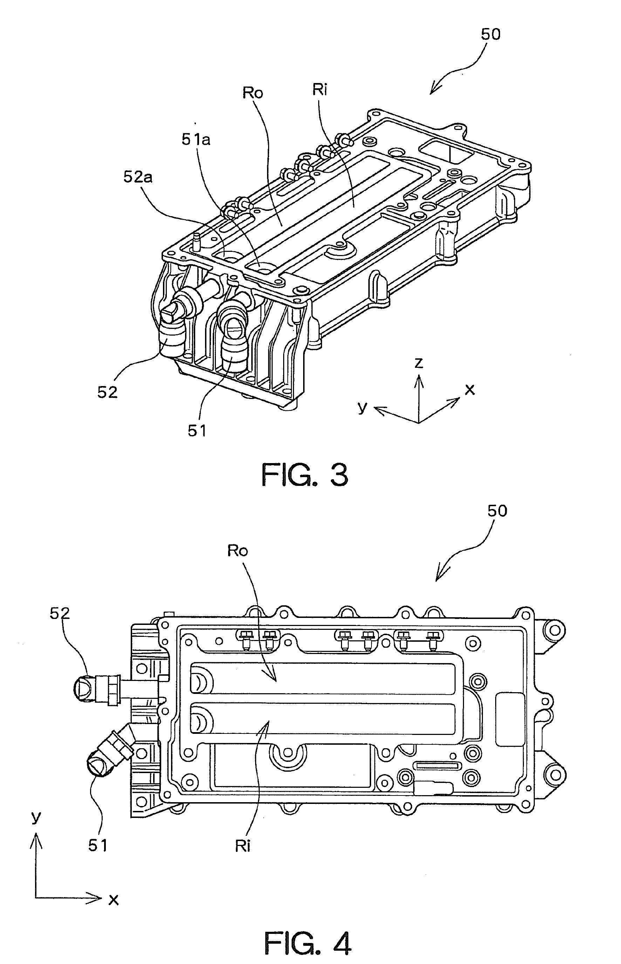

   FIG. 3 is a schematic perspective view illustrating the basic structure according to the embodiment.
[FIG. 4]
   FIG. 4 is a plan view illustrating the basic structure according to the embodiment.
[FIG. 5]

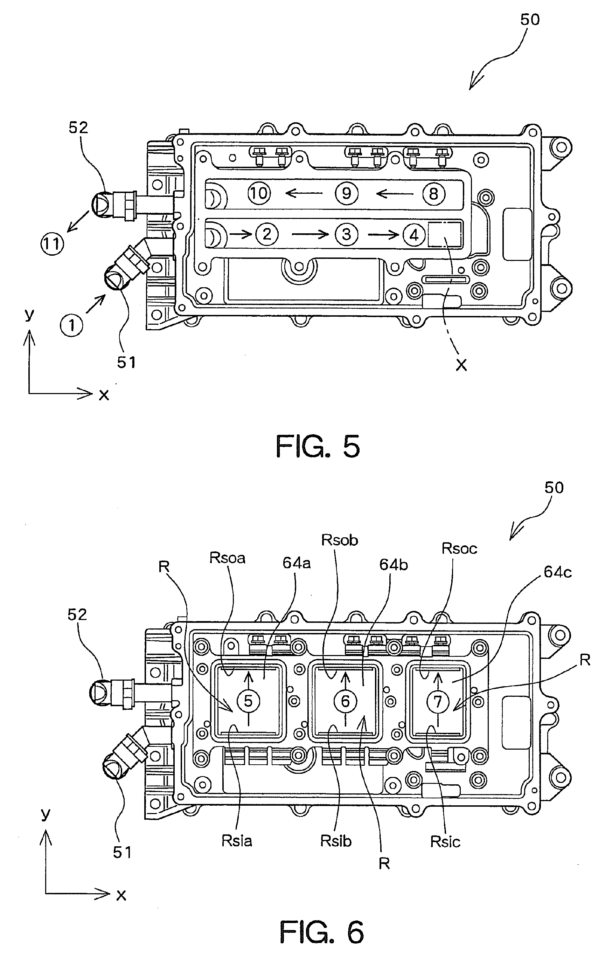

   FIG. 5 is a schematic diagram illustrating the flow of a coolant in the basic structure according to the embodiment.
[FIG. 6]
   FIG. 6 is a schematic diagram illustrating the flow of a coolant in the basic structure according to the embodiment.
[FIG. 7]

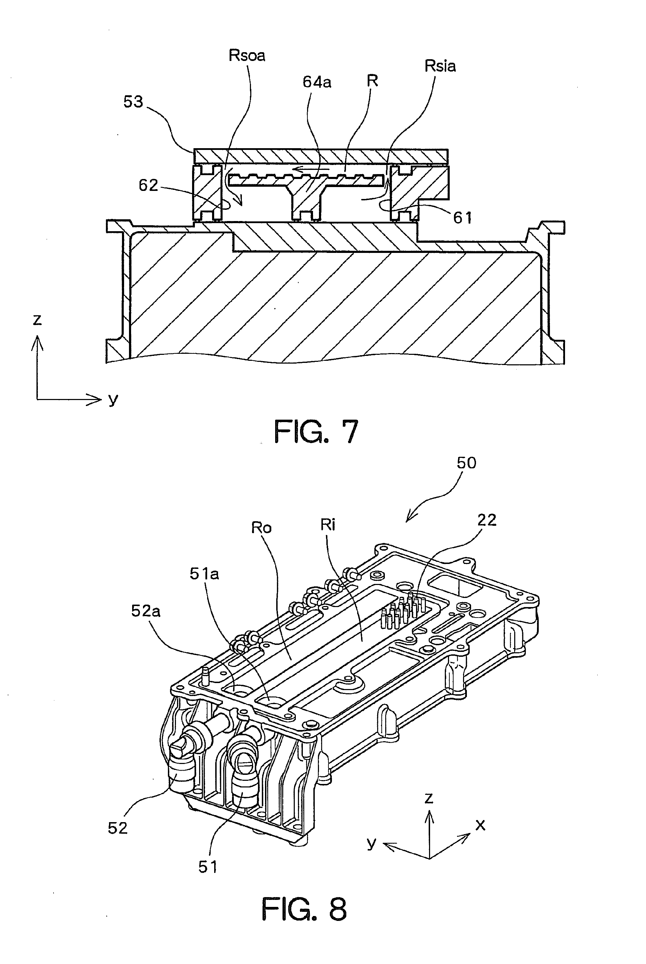

   FIG. 7 is a longitudinal cross-sectional view of the basic structure according to the embodiment.
[FIG. 8]
   FIG. 8 is a schematic perspective view according to a first embodiment.
[FIG. 9]

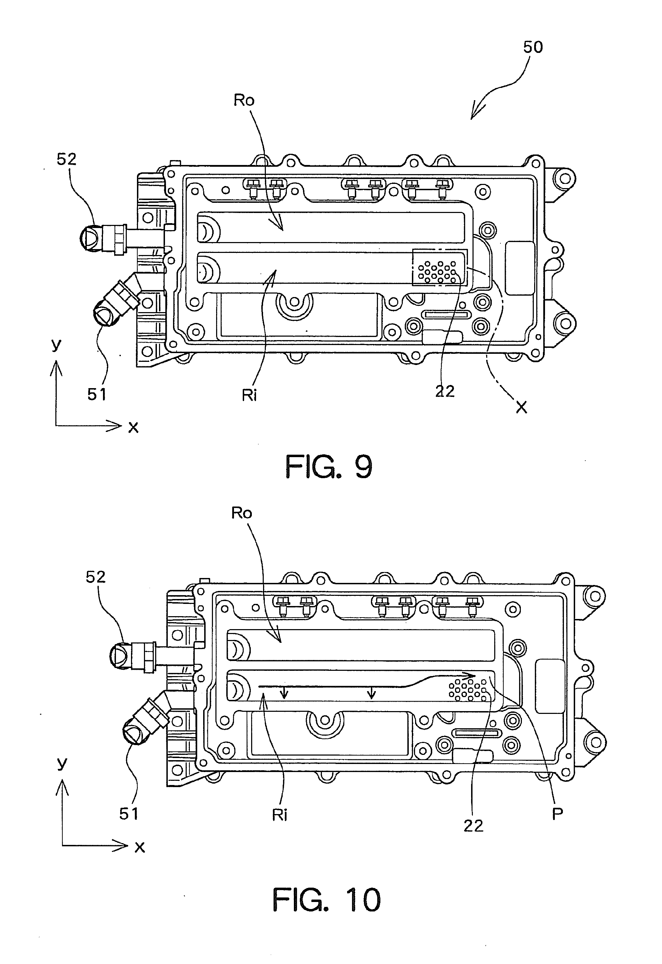

   FIG. 9 is a plan view according to the first embodiment.
[FIG. 10]
   FIG. 10 is a schematic diagram illustrating the flow of a coolant according to the first embodiment.
[FIG. 11]

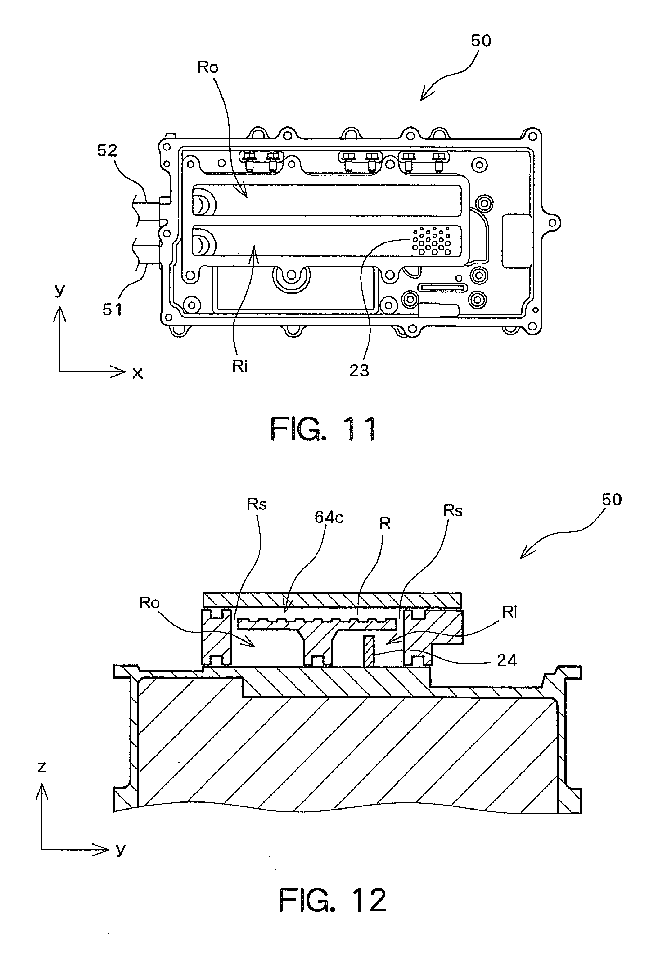

   FIG. 11 is a plan view according to a second embodiment.
[FIG. 12]
   FIG. 12 is a longitudinal cross-sectional view according to a third embodiment.
[FIG. 13]

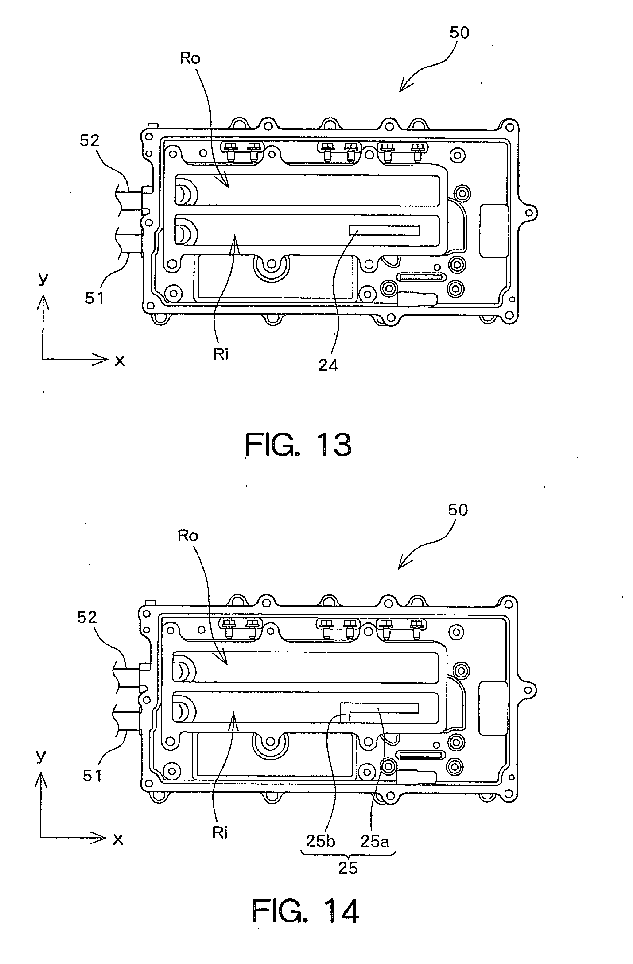

   FIG. 13 is a plan view according to the third embodiment.
[FIG. 14]
   FIG. 14 is a plan view according to a fourth embodiment.
[FIG. 15]

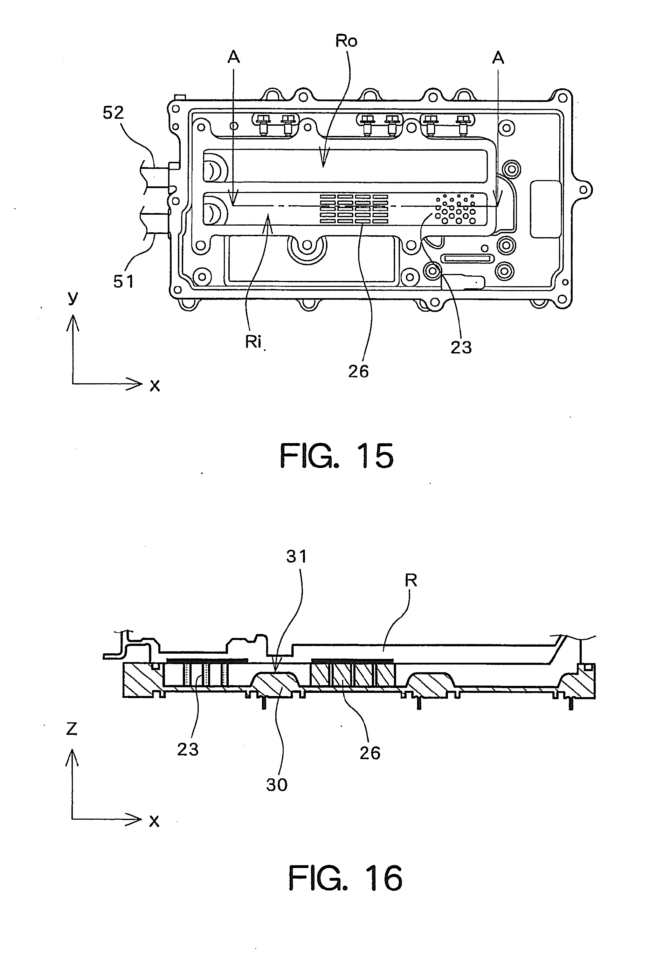

   FIG. 15 is a plan view according to a fifth embodiment.
[FIG. 16]
   FIG. 16 is a cross-sectional view of a modification.
[FIG. 17]
   FIG. 17 is a plan view of the modification.
[FIG. 18]
   FIG. 18 is an overall perspective view of a conventional technique.
[FIG. 19]
   FIG. 19 is a cross-sectional view of a cooling structure of the conventional technique.
[FIG. 20]
   FIG. 20 is a cross-sectional view of the cooling structure of the conventional technique.

### EMBODIMENTS FOR CARRYING OUT THE INVENTION

Embodiments of the present invention will be described below with reference to the drawings. It should be noted that components identical or corresponding to those of the conventional cooling structure illustrated in FIGs. 18, 19, and 20 are denoted by the same reference numerals. Further, the following embodiments are given only by way of example, and the present invention is not limited to those embodiments.

### 1. Basic Structure

First, before description of the embodiments, a basic structure constituting a precondition for the embodiments will be described below. The basic structure of a cooler according to an embodiment includes the same components as those of the conventional cooling structure illustrated in FIGs. 18, 19, and 20. Specifically, the cooler according to the embodiment also has a coolant space R formed between the heat dissipation surface 53a of the heat sink 53 and the opposing surface 6a of the spacer 6. In this coolant space R, a plurality of heat dissipation fins 56 standing upright from the heat dissipation surface 53a toward the opposing surface 6a may be arranged parallel with each other as needed to form inter-fin passages Rp through which the coolant flows, between every two of the plurality of heat dissipation fins 56 that are positioned adjacent to each other. However, the heat dissipation fins 56 are optional. According to the embodiment, a structure having no heat dissipation fins 56 will be described below.

An inflow-side coolant reservoir Ri is formed by the recessed portion 61 of the spacer 6 and the upper face of the drive unit case 2 to be in communication with the coolant space R. Further, an outflow-side coolant reservoir Ro is formed by the recessed portion 62 of the spacer 6 and the upper face of the drive unit case 2 to be in communication with the coolant space R. The inflow-side coolant reservoir Ri and one end of the coolant space R are brought into communication with each other through a narrowed portion Rs, and the outflow-side coolant reservoir Ro and another end of the coolant space are brought into communication with each other through a narrowed portion Rs.

An inflow-side port 51 that allows the coolant to flow into the inflow-side coolant reservoir Ri is joined to the inflow-side coolant reservoir Ri to communicate therebetween, and an outflow-side port 52 that allows the coolant to flow out of the outflow-side coolant reservoir Ro is joined to the outflow-side coolant reservoir Ro to communicate therebetween. The coolant supplied to the inflow-side coolant reservoir Ri by means of a coolant pump 41 provided on the coolant circulation path is allowed to flow into the coolant space R via the narrowed portion Rs, so that a heat generator such as the inverter 3 is cooled through the medium of the heat dissipation surface 53a. After cooling the inverter 3, the coolant is caused to flow out to the outflow-side coolant reservoir Ro via the narrowed portion Rs. Further, a heat generator present within the drive unit case 2, such as a motor or a reactor, is cooled by the coolant flowing within the inflow-side coolant reservoir Ri. According to the embodiment, by means of the heat sink 53 present on the upper surface of the cooling space R, the cooler 50 cools a heat generator present above the cooling space R, and also cools a heat generator present below the inflow-side coolant reservoir Ri.

FIG. 1 illustrates a schematic perspective view of the basic structure of the cooler 50 according to the present embodiment. Further, FIG. 2 illustrates a plan view of the cooler 50. A spacer 64 corresponding to the spacer 6 is formed to be divided into three areas 64a, 64b, and 64c in the x direction of three orthogonal axes x-y-z. The reason that the spacer 64 is divided into three areas is to correspond to a structure wherein a heat generator such as the inverter 3 located above the cooler 50 is broadly composed of three units. An inflow-side coolant reservoir Ri and an outflow-side coolant reservoir Ro are formed within the spacers 64a, 64b, and 64c. As illustrated in FIG. 2, an inflow-side narrowed portion Rsi is formed at one end of each of the spacers 64a, 64b, and 64c, and is in communication with the inflow-side coolant reservoir Ri. Specifically, a narrowed portion Rsia is formed at one end of the spacer 64a, and the narrowed portion Rsia is in communication with the inflow-side coolant reservoir Ri. Further, a narrowed portion Rsib is formed at one end of the spacer 64b, and the narrowed portion Rsib is also in communication with the inflow-side coolant reservoir Ri. Still further, a narrowed portion Rsic is formed at one end of the spacer 64c, and the narrowed portion Rsic is also in communication with the inflow-side coolant reservoir Ri. Also, an outflow-side narrowed portion Rso is formed at the other end of the spacer 64 in the y direction, and is in communication with the outflow-side coolant reservoir Ro. Specifically, a narrowed portion Rsoa is formed at the other end of the spacer 64a, and the narrowed portion Rsoa is in communication with the outflow-side coolant reservoir Ro. Further, a narrowed portion Rsob is formed at the other end of the spacer 64b, and the narrowed portion Rsob is in communication with the outflow-side coolant reservoir Ro. Still further, a narrowed portion Rsoc is formed at the other end of the spacer 64c, and the narrowed portion Rsoc is also in communication with the outflow-side coolant reservoir Ro. In FIG. 2, the coolant space R is formed above each of the spacers 64a, 64b, and 64c (toward the front of the page in FIG. 2).

The inflow-side port 51 is in communication with one end of the inflow-side coolant reservoir Ri in the x direction, and a coolant is supplied to the inflow-side coolant reservoir Ri through this inflow-side port 51. Although any coolant may be used, for example, cooling water is used. The coolant supplied to the inflow-side coolant reservoir Ri flows into the coolant space R via the narrowed portions Rsia, Rsib, and Rsic formed for each of the three spacers 64a, 64b, and 64c. After flowing through the coolant space R, and cooling a heat generator such as the inverter 3, the coolant flows out to the outflow-side coolant reservoir Ro via the narrowed portions Rsoa, Rsob, and Rsoc formed at the other ends of the spacers 64a, 64b, and 64c. The coolant that has flowed out to the outflow-side coolant reservoir Ro is caused to flow out to the coolant circulation path through the outflow-side port 52.

FIG. 3 illustrates a schematic perspective view of the cooler 50 in a state in which the spacer 64 is removed. Further, FIG. 4 illustrates a plan view of the cooler 50 from which the spacer 64 is removed. The inflow-side coolant reservoir Ri (in FIGs. 3 and 4, the bottom face of the inflow-side coolant reservoir Ri is shown) is formed to extend in the x direction. Further, the outflow-side coolant reservoir Ro (in FIGs. 3 and 4, the bottom face of the outflow-side coolant reservoir Ro is shown) is also formed to extend in the x direction. The inflow-side coolant reservoir Ri and the outflow-side coolant reservoir Ro are arranged parallel with each other in the y direction. The inflow-side coolant reservoir Ri and the outflow-side coolant reservoir Ro are both formed within recessed portions of the spacer 64 which are arranged parallel with each other. In the inflow-side coolant reservoir Ri and the outflow-side coolant reservoir Ro, communication holes 51a and 52a communicating with the inflow-side port 51 and the outflow-side port 52 are respectively formed at the ends on one side in the x direction. Via these communication holes 51a and 52a, the coolant is caused to flow into the inflow-side coolant reservoir Ri, and after cooling, is caused to flow out of the outflow-side coolant reservoir Ro.

FIGs. 5 and 6 schematically illustrate a flow of a coolant that is supplied through the inflow-side port 51 until it flows out through the outflow-side port 52. FIG. 5 illustrates a plan view of the cooler 50 from which the spacer 64 is removed, and FIG. 6 illustrates a plan view of the cooler 50 including the spacer 64. The coolant that has flowed into the inflow-side coolant reservoir Ri through the inflow-side port 51 flows in the order of numbers 1, 2, 3, and 4 shown in FIG. 5:
1 to 2 to 3 to 4.
In other words, the coolant flows in the direction in which the inflow-side coolant reservoir Ri extends (in the x direction). Here, the side communicating with the inflow-side port 51 of the inflow-side coolant reservoir Ri is defined as the upstream side, and the opposite side is defined as the downstream side.

Further, the coolant that has flowed into the inflow-side coolant reservoir flows into the coolant space R via the inflow-side narrowed portions Rsia, Rsib, and Rsic. Specifically, some of the coolant that has flowed into the inflow-side coolant reservoir Ri diverts and flows into the coolant space R via the inflow-side narrowed portion Rsia of the spacer 64a. Further, some of the coolant flows into the coolant space R via the inflow-side narrowed portion Rsib of the spacer 64b. Still further, some of the coolant flows into the coolant space R via the inflow-side narrowed portion Rsic of the spacer 64c. In FIG. 6, the above-described diverting flows are represented by numbers 5, 6, and 7. Specifically, the coolant that has flowed into the inflow-side coolant reservoir Ri diverts and flows into the coolant space R in the order of:
1 to 2 to 5,
1 to 2 to 3 to 6, or
1 to 2 to 3 to 4 to 7.

The coolant that has flowed through the coolant space R and has cooled the heat generator flows out to the outflow-side coolant reservoir Ro via the outflow-side narrowed portions Rsoa, Rsob, and Rsoc, and flows in the order of numbers 8, 9, 10, and 11 shown in FIG. 5:
8 to 9 to 10 to 11,
to flow out through the outflow-side port 52.

In summary, the flow of the coolant within the cooler 50 includes three streams of flow:
1 to 2 to 5 to 10 to 11,
1 to 2 to 3 to 6 to 9 to 10 to 11, and
1 to 2 to 3 to 4 to 7 to 8 to 9 to 10 to 11.
These streams of the coolant cool the heat generator present on the upper face of the cooling space R, and cool the heat generator present on the lower face of the inflow-side coolant reservoir Ri.

FIG. 7 illustrates a longitudinal cross-sectional view of the cooler 50 taken at the position at which the spacer 64a is present. In the spacer 64a, the recessed portions 61 and 62 are formed to be arranged parallel with each other in the y direction, and respectively constitute the inflow-side coolant reservoir Ri and the outflow-side coolant reservoir Ro. The coolant that has flowed into the inflow-side coolant reservoir Ri cools the opposing surface 61, and flows through the coolant space R via the inflow-side narrowed portion Rsia formed at one end of the spacer 64a to cool the heat sink 53. After cooling, the coolant flows out to the outflow-side coolant reservoir Ro via the outflow-side narrowed portion Rsoa formed at the other end of the spacer 64a.

Among the above-described streams of the coolant, the stream flowing via the inflow-side narrowed portion Rsia which is located closest to the inflow-side port 51 and is the most upstream among the inflow-side narrowed portions Rsia, Rsib, and Rsic formed in the spacer 64:
1 to 2 to 5 to 10 to 11
has the highest flow rate. The stream flowing via the inflow-side narrowed portion Rsib located next upstream of the inflow-side narrowed portion Rsia:
1 to 2 to 3 to 6 to 9 to 10 to 11
has the second highest flow rate. As such, the amount of the coolant flowing in the order of:
1 to 2 to 3 to 4 to 7 to 8 to 9 to 10 to 11
is relatively low compared to the other streams. In the downstream side end portion of the inflow-side coolant reservoir Ri, or specifically, in the area X illustrated in FIG. 5, the flow rate of the coolant is low and the cooling performance is degraded. Also, air tends to dwell in the area X.

To address the above-described situation, according to the embodiment, some improvements to the basic structure are made in order to increase the flow velocity of the coolant flowing in the order of:
1 to 2 to 3 to 4 to 7 to 8 to 9 to 10 to 11.
The basic principles for increasing the flow velocity of the coolant in an area located near the downstream side end portion of the inflow-side coolant reservoir Ri, that is, in the area X, are to reduce the coolant flow channel cross-sectional area in the area X while allowing the coolant to flow into the inflow-side narrowed portion Rsic, so that the flow velocity is increased. In order to reduce the flow channel cross-sectional area in the area X, a regulator for reducing and regulating the flow channel cross-sectional area is formed in the area X. The regulator for reducing and regulating the flow channel cross-sectional area is, for example, a fin which is formed to stand upright in the area X, or a guide which is formed to stand upright in the area X. By increasing the flow velocity of the coolant in an area located upstream of the area X, the flow velocity of the coolant in the area X can also be increased.

The structure of the embodiment will be specifically described below.

### 2. First Embodiment

FIG. 8 illustrates a schematic perspective view of the cooler 50 according to a first embodiment. The perspective view shows a state in which the spacer 64 is removed, and corresponds to FIG. 3 of the basic structure.

As can be seen from the comparison between FIG. 3 and FIG. 8, according to the present embodiment, a plurality of non-directional fins, for example, pin fins 22, are formed to stand upright in the downstream side end portion of the inflow-side coolant reservoir Ri. The pin fins 22 are formed to stand upright from the bottom face of the inflow-side coolant reservoir Ri toward the coolant space R.

FIG. 9 illustrates a plan view of the cooler 50 illustrated in FIG. 8. The pin fins 22 formed in the area located near the downstream side end portion of the inflow-side coolant reservoir Ri, that is, in the area X in FIG. 5, are not formed to be equally spaced in the area X, but are non-uniformly formed to stand upright to be unevenly distributed toward the side closer to the inflow-side narrowed portion Rsic formed at one end of the spacer 64c in the area X. In other words, no pin fin 22 is formed or present on the opposite side to the inflow-side narrowed portion Rsic in the y direction in the area X. More specifically, when the inflow-side coolant reservoir Ri in the area X is divided into four equal portions in the y direction, the pin fins 22 are formed to stand upright in the 3/4 area as viewed from the side closer to the inflow-side narrowed portion Rsic, and no pin fin 22 is present in the remaining 1/4 area. It should be understood that this configuration is given by way of example. Alternatively, when the inflow-side coolant reservoir Ri in the area X is divided into two equal portions in the y direction, it is possible to employ a configuration in which the pin fins 22 are formed to stand upright in the 1/2 area as viewed from the side closer to the inflow-side narrowed portion Rsic, and no pin fin 22 is present in the remaining 1/2 area. When the inflow-side coolant reservoir Ri in the area X is divided into three equal portions in the y direction, it is also possible to employ a configuration in which the pin fins 22 are formed to stand upright in the 2/3 area as viewed from the side closer to the inflow-side narrowed portion Rsic, and no pin fin 22 is present in the remaining 1/3 area. Further, it is also possible to employ a configuration in which the pin fins 22 are formed to stand upright over the overall area X, but a greater number of pin fins 22 are formed to stand upright on the side closer to the inflow-side narrowed portion Rsic. In short, the density of the pin fins 22 formed to stand upright in the area X is configured to vary in the y direction so that the density becomes greater in an area closer to the inflow-side narrowed portion Rsic. A difference in flow velocity of the coolant in the area X arises because the pin fins 22 are non-uniformly formed to stand upright to be unevenly distributed toward the side closer to the inflow-side narrowed portion Rsic. The flow velocity of the coolant decreases in an area where the pin fins 22 are formed to stand upright, whereas the flow velocity of the coolant relatively increases in an area where no pin fin 22 is formed to stand upright, or in an area where the pin fins 22 are formed to stand upright at a relatively low density.

FIG. 10 illustrates the flow of the coolant within the inflow-side coolant reservoir Ri according to the present embodiment. The coolant supplied through the inflow-side port 51 flows from upstream to downstream, and also diverts and flows to the inflow-side narrowed portions Rsia and Rsib. Further, the coolant flows into the area X in the downstream end portion. In the area X, the pin fins 22 are formed to stand upright to be unevenly distributed, and the pin fins 22 cause the flow velocity of the coolant to decrease. On the other hand, the flow velocity of the coolant relatively increases in an area where no pin fin 22 is present, or in an area where the pin fins 22 are formed to stand upright at a relatively low density. Therefore, the coolant causes air dwelling in the area X to be discharged. In particular, the amount of air dwelling at the corner in the downstream side end portion denoted by the sign P in FIG. 10 is effectively reduced, and the cooling performance in the area X is improved. The area where the pin fins 22 are formed to stand upright or the area where the pin fins 22 are formed to stand upright at a relatively high density is a relatively high pressure loss area, and the area where no pin fin 22 is formed to stand upright or the area where the pin fins 22 are formed to stand upright at a relatively low density is a relatively low pressure loss area. It can be said that the pin fins 22 produce a relatively low pressure loss area and a relatively high pressure loss area in the area X to increase the flow velocity of the coolant. In other words, it can be said that the pin fins 22 reduce the flow channel cross-sectional area in the area X to increase the flow velocity of the coolant in the area X.

### 3. Second Embodiment

FIG. 11 illustrates the structure of the cooler 50 according to a second embodiment. FIG. 11 is a plan view of the cooler 50 in a state in which the spacer 64 is removed. A plurality of pin fins 23 are formed to stand upright in an area located near the downstream side end portion of the inflow-side coolant reservoir Ri, or in other words, in the area X. The pin fins 23 are formed to stand upright from the bottom face of the inflow-side coolant reservoir Ri toward the coolant space R. Although the pin fins 23 are formed to stand upright to be approximately uniformly spaced apart in the area X, the fins have different fin sizes (diameters). Specifically, the pin fins 23 have relatively large fin diameters on the side closer to the inflow-side narrowed portion Rsic, and the pin fins 23 have relatively small fin diameters on the side opposite to the inflow-side narrowed portion Rsic. In short, the fin diameters of the pin fins 23 vary in the y direction in such a manner that the closer to the inflow-side narrowed portion Rsic the larger the fin diameters. The fin diameters of the pin fins 23 may vary continuously, or stepwise.

By employing such a structure, the flow velocity of the coolant varies in accordance with the size of the diameters of the pin fins 23, and the flow velocity of the coolant relatively increases in areas where the pin fins 23 have a relatively small diameter. Therefore, air dwelling in the area X is effectively discharged, and the cooling performance in the area X is improved.

Although, according to the present embodiment, the fin diameters of the pin fins 23 vary sequentially in the y direction, the fin diameters of the pin fins 23 may also vary, for example, in two levels so that pin fins 23 having a relatively large fin diameter are formed to stand upright on the side closer to the narrowed portion Rsic, and pin fins 23 having a relatively small fin diameter are formed to stand upright on the opposite side.

### 4. Third Embodiment

FIGs. 12 and 13 illustrate the structure of the cooler 50 according to a third embodiment. FIG. 12 is a longitudinal cross-sectional view of the cooler 50 at a position where the spacer 64c is present, and FIG. 13 is a plan view in a state in which the spacer 64 is removed. As illustrated in FIGs. 12 and 13, a guide 24 is formed to stand upright in an area located near the downstream side end portion of the inflow-side coolant reservoir Ri, or, in other words, in the area X. The guide 24 is formed to stand upright from the bottom face of the inflow-side coolant reservoir Ri, and extends in the direction in which the inflow-side coolant reservoir Ri extends (in the x direction). However, the guide 24 does not reach the downstream side end of the inflow-side coolant reservoir Ri, and a space is formed between the guide 24 and the downstream side end. Referring to FIGs. 12 and 13, the guide 24 is formed to stand upright approximately at the center of the inflow-side coolant reservoir Ri in the width direction (y direction) to divide the flow channel of the coolant in the area X into two areas. Although the guide 24 in FIG. 12 is formed to stand upright from the bottom face of the inflow-side coolant reservoir Ri toward the coolant space R, and does not reach the spacer 64c with a space being present between the guide 24 and the spacer 64c, the guide 24 may also be formed to stand upright until it reaches the spacer 64c.

By employing such a structure, because the guide 24 reduces the flow channel cross-sectional area in the area X of the inflow-side coolant reservoir Ri, the flow velocity of the coolant in the area X relatively increases. As the flow velocity of the coolant relatively increases, air dwelling in the area X is effectively discharged, and the cooling performance is improved.

### 5. Fourth Embodiment

FIG. 14 illustrates the structure of the cooler 50 according to a fourth embodiment. FIG. 14 is a plan view in which the spacer 64 is removed. Although, as in the third embodiment, a guide 25 is formed to stand upright in the downstream side end portion of the inflow-side coolant reservoir Ri, or in other words, in the area X, the guide 25 has a shape different from that of the guide 24, and is L-shaped when viewed in a plan view. Specifically, the guide 25 is composed of a portion 25a extending in the direction in which the inflow-side coolant reservoir Ri extends (in the x direction), and a portion 25b which is a portion of the guide 25 bent to be approximately perpendicular to the x direction and in contact with an internal side surface of the inflow-side coolant reservoir Ri. As the portion 25b is approximately perpendicular to the direction in which the inflow-side coolant reservoir Ri extends, the portion 25b restricts the downstream flow of the coolant, and narrows the flow channel of the coolant in the area X. The guide 25 is formed to stand upright from the bottom face of the inflow-side coolant reservoir Ri toward the coolant space R. The guide 25 may be formed such that it does not reach the spacer 64c and a space is formed between the guide 25 and the spacer 64c, or may also be formed to stand upright such that it reaches the spacer 64c. As the flow of the coolant is inhibited by the portion 25b, the coolant flows through a portion of the flow channel in which the portion 25b is absent to flow in the area X, and is turned back by the downstream side end portion to proceed around to the downstream side of the portion 25b.

By employing such a structure, because the guide 25 reduces the flow channel cross-sectional area in the area X of the inflow-side coolant reservoir Ri, the flow velocity of the coolant in the area X relatively increases, dwelling air is effectively discharged, and the cooling performance is improved.

### 6. Fifth Embodiment

FIG. 15 illustrates the structure of the cooler 50 according to a fifth embodiment. FIG. 15 is a plan view in which the spacer 64 is removed. As in the second embodiment, a plurality of pin fins 23 are formed to stand upright in the downstream side end portion of the inflow-side coolant reservoir Ri, or in other words, in the area X. The diameters of the pin fins 23 are not the same, and vary in the y direction such that the closer to the inflow-side narrowed portion Rsic the larger the diameters. Further, a plurality of rectangular fins 26 are discretely formed to stand upright in an area located on the upstream side of the area X and corresponding to the position where the spacer 64b is present (for the sake of convenience, this area is referred to as area Y). The plurality of rectangular fins 26 have the same shape, and are formed to stand upright at an approximately uniform density. Because the plurality of rectangular fins 26 are discretely formed, even when the rectangular fins 26 are formed to stand upright from the bottom face and extend until they reach the spacer, the coolant flows into the inflow-side narrowed portion Rsib of the spacer 64b. As the rectangular fins 26 reduce the coolant flow channel cross-sectional area, the flow velocity of the coolant increases. Also, because the coolant having an increased flow velocity flows into the area X located on the downstream side, the flow velocity of the coolant in the area X relatively increases. Further, because the pin fins 23 are formed to stand upright in the area X, the flow velocity of the coolant relatively further increases, and dwelling air is effectively discharged.

### 7. Modifications

Although the embodiments of the present invention have been described above, other modifications are also possible. For example, in the structure of FIG. 11, the pin fins 23 not only have varying diameters, but the pin fins 23 may also be formed to stand upright at a varying density in addition to having varying diameters. Specifically, the closer to the inflow-side narrowed portion Rsic in the y direction, the greater the diameters of the pin fins 23, and the greater the density at which the pin fins 23 are formed to stand upright.

Further, in FIG. 15, in place of the rectangular fins 26 formed to stand upright in the area Y, pin fins may be formed to stand upright.

Further, in FIG. 15, in place of the pin fins 23, the pin fins 22 illustrated in FIG. 8 or 9 may be formed to stand upright.

Further, in FIG. 15, in place of the pin fins 23, the guide 24 of FIG. 13 or the guide 25 of FIG. 14 may be formed to stand upright.

Further, in FIG. 15, a component for further reducing the flow channel cross-sectional area in an area between the area X where the pin fins 23 are formed to stand upright and the area Y where the rectangular fins 26 are formed to stand upright may be provided.

FIG. 16 illustrates a structure for this case. FIG. 16 is a cross-sectional view of FIG. 15 taken along line A-A. A projection 30 projecting from the bottom in the inflow-side coolant reservoir Ri is provided in an area between the area X and the area Y, or in other words, in an area located upstream of the area X and located downstream of the area Y, to reduce the flow channel cross-sectional area of the flow channel 31 of the coolant in this area. By employing this structure, the flow velocity of the coolant flowing into the area X relatively increases.

In summary, the structures of the embodiments of the present invention and their modifications include the following cases, wherein, as illustrated in FIG. 17, an area located near the downstream side end portion of the inflow-side coolant reservoir Ri is denoted as area X, an area located upstream of the area X and corresponding to a location where a heat generator to be cooled by the cooler 50 is present is denoted as area Y, and an area located between the area X and the area Y and corresponding to an area where no heat generator is present is denoted as area Z:
(1) The pin fins 22, the pin fins 23, the guide 24, or the guide 25 is formed to stand upright as a regulator in the area X.
(2) The pin fins 22, the pin fins 23, the guide 24, or the guide 25 is formed to stand upright as a regulator in the area X, and the pin fins 22, the pin fins 23, the guide 24, the guide 25, or the rectangular fins 26 are formed to stand upright as a second regulator in the area Y.
(3) The pin fins 22, the pin fins 23, the guide 24, or the guide 25 is formed to stand upright as a regulator in the area X, and the projection 30 is formed as a third regulator in the area Z.
(4) The pin fins 22, the pin fins 23, the guide 24, or the guide 25 is formed to stand upright as a regulator in the area X, the pin fins 22, the pin fins 23, the guide 24, the guide 25, or the rectangular fins 26 are formed to stand upright as a second regulator in the area Y, and the projection 30 is formed as a third regulator in the area Z.

Further, although, according to the embodiments of the present invention, a structure wherein the spacer 64 is divided into three areas, that is, the spacers 64a, 64b, and 64c, as illustrated in FIG. 1 is described by way of example, it is unnecessary to always divide the spacer 64. Further, when the spacer 64 is divided, the spacer 64 may also be divided into two, four, or more as needed. Whether or not to divide the spacer 64 is determined based on the manner in which a heat generator to be cooled is installed.

### REFERENCE NUMERALS

- 22, 23: PIN FIN
- 24, 25: GUIDE
- 50: COOLER
- 51: INFLOW-SIDE PORT
- 52: OUTFLOW-SIDE PORT
- 64: SPACER
- Ri: INFLOW-SIDE COOLANT RESERVOIR
- Ro: OUTFLOW-SIDE COOLANT RESERVOIR

## Claims

1. A cooler comprising:
a coolant space through which a coolant flows;
an inflow-side coolant reservoir which is in communication with one end side of the coolant space via an inflow-side narrowed portion; and
an outflow-side coolant reservoir which is in communication with another end side of the coolant space via an outflow-side narrowed portion, wherein
the inflow-side coolant reservoir and the inflow-side narrowed portion are formed to extend in a first direction,
a coolant supplied to the inflow-side coolant reservoir flows along the first direction, flows through the coolant space via the inflow-side narrowed portion, and flows out to the outflow-side coolant reservoir via the outflow-side narrowed portion, and
a regulator is formed in an area located near a downstream side end portion of the inflow-side coolant reservoir, the regulator reducing and regulating a flow channel cross-sectional area to increase a flow velocity of the coolant in this area.

2. The cooler according to claim 1, wherein the regulator comprises fins.

3. The cooler according to claim 2, wherein the fins are pin fins.

4. The cooler according to claim 3, wherein the pin fins are formed to be unevenly distributed toward the side with which the inflow-side narrowed portion is in communication.

5. The cooler according to claim 3, wherein the pin fins have relatively large fin diameters on the side with which the inflow-side narrowed portion is in communication.

6. The cooler according to claim 3, wherein the pin fins are formed at a relatively high density on the side with which the inflow-side narrowed portion is in communication.

7. The cooler according to claim 1, wherein the regulator is a guide formed along the first direction.

8. The cooler according to claim 7, wherein the guide is composed of a first portion formed along the first direction and a second portion extending in a direction approximately perpendicular to the first direction and restricting a downstream flow of the coolant.

9. The cooler according to claim 1, further comprising:
a second regulator formed further upstream of the area located near the downstream side end portion, the second regulator reducing and regulating the flow channel cross-sectional area of the inflow-side coolant reservoir.

10. The cooler according to claim 9, wherein the second regulator comprises fins formed along the first direction.

11. The cooler according to claim 9, further comprising:
a third regulator formed between the regulator and the second regulator, the third regulator reducing and regulating the flow channel cross-sectional area of the inflow-side coolant reservoir.

12. The cooler according to claim 11, wherein the third regulator is a projection formed in the inflow-side coolant reservoir.
